# EUROPEAN PATENT SPECIFICATION

(11) **EP 0 356 059 B1**
(45) Date of publication and mention of the grant of the patent: **26.01.2000**
(21) Application number: 89308007.7
(22) Date of filing: 07.08.1989
(51) Int. Cl.: H01L 21/38, H01L 21/477, H01L 33/00

(54) **Process for doping crystals of wide band gap semiconductors**
Dotierungsverfahren für Halbleiterkristalle mit grosser Bandlücke
Procédé pour doper des cristaux semi-conducteurs à large bande interdite

(30) Priority: 15.08.1988 US 232405; 22.08.1988 US 234802
(43) Date of publication of application: 28.02.1990
(60) Divisional application: 99102455.5
(73) Proprietor: Neumark, Gertrude F., Hartsdale New York 10530 (US)
(72) Inventor: Neumark, Gertrude F., Hartsdale New York 10530 (US)
(74) Representative: Allam, Peter Clerk

(56) References cited:
- FR-A- 2 613 136
- SEMICONDUCTOR SCIENCE & TECHNOLOGY, vol. 2, no. 10, October 1987, pages 629-635, IOP Publishing Ltd, Bristol, GB; F. EL. AKKAD: "Lithium and phosphorus impurities in ZnTe"
- JOURNAL OF APPLIED PHYSICS, vol. 42, no. 7, June 1971, pages 2919-2924; B. TELL: "Properties of the alkalis in CdS"
- JOURNAL OF ELECTRONIC MATERIAL, vol. 5, no. 1, February 1976, pages 23-35, Plenum Publishing Corp., New York, US; Z.K. KUN et al.: "Some characteristics of the formation of high conductivity P-layers in ZnSe and ZnSxSe1-x
- PATENT ABSTRACTS OF JAPAN, vol. 12, no. 423 (E-680), 9th November 1988; & JP-A-63 160 344 (TOSHIBA CORP.) 04-07-1988
- APPLIED PHYSICS LETTERS, vol. 52, no. 1, 4th January 1988, pages 57-59, American Institute of Physics; T. YASUDA et al.: "Metalorganic vapor phase epitaxy of low-resistivity p-type ZnSe"

## Description

This invention relates to the preparation of crystals of wide band gap semiconductors for use in electronic devices.

As is known, crystals of semiconductors are of great interest in the manufacture of sophisticated electronic devices. The useful properties of semiconductive crystals depend not only on the particular semiconductor that forms the crystal but also importantly on the trace amounts of donor or acceptor dopants that are incorporated in the crystal lattice. These dopants contribute the hole and electron charge carriers that are responsible for the useful electronic properties of the crystals.

With many potentially useful semiconductive crystals, particularly those in which the host material is a wide band-gap semiconductor (a band gap of at least 1.4 electron volts), such as zinc selenide, it has been difficult to incorporate into the crystal lattice in reproducible fashion adequate amounts of both types of dopant to provide good p-n junctions, i.e., both n-type and p-type conductivity. As a consequence, it has not been practical to use such semiconductors widely in devices where bipolar conductivity is important.

In particular, although n-type zinc selenide has been available which conducts "well" (defined as having a resistivity equal to or less than 10³ ohm-centimeter), this has not been the case with p-type zinc selenide. The standard practice for preparing "well-conducting" n-type zinc selenide involves the extraction of impurities, such as copper, by annealing. Such annealing is known to extract copper that is accidentally introduced during the preparation of bulk material.

More recently n-type zinc selenide has been prepared using low temperature growth methods, such as metal-organo-chemical vapor deposition (MOCVD) and molecular beam epitaxy (MBE) with selective incorporation of appropriate dopants.

However, with respect to p-type zinc selenide, it has been difficult to obtain "well-conducting" material reliably in reproducible fashion. There have been recent claims that such material has been realized by the introduction of Li₃N. Others have claimed to have obtained it by the introduction of gallium, indium or thallium by heat treatment and diffusion. However, the understanding of these techniques has been poor with the result that there is little confidence in applying these techniques to commercial products.

A method for producing high conductivity p-type ZnSe and ZnSₓSe₁₋ₓ is disclosed in a paper by Z.K. Kun and R.J. Robinson (Journal of Electronic Materials 5 (1976) 23-35). The method involves use of an Iodine-doped n-type substrate into which a group IIIA element such as Gallium, Indium or Thallium is diffused. P-type conductivity is achieved in the diffused layer by treatment at high pressure with zinc vapour in a "conversion" step, during which the authors speculate that some of the diffused group IIIA dopant is reduced from the trivalent to the monovalent or elemental state.

There is needed a better-understood technique, amenable to good control, for doping hard-to-dope wide band gap semiconductors, such as zinc selenide, zinc sulphide, cadmium sulphide, cadmium selenide, zinc telluride and diamond.

It is believed by the inventor that energy and solubility considerations form the basic difficulty in incorporating particular dopants into crystals of the kind under discussion. Such considerations predict a strong tendency for compensation between donors and acceptors in wide band gap materials. Accordingly, the achievement of adequate conductivity will require "non-equilibrium impurity incorporation". This term means the incorporation of a dopant (impurity) in excess of its equilibrium solubility at a particular temperature and concentration of compensating species. As is also known, the solubility of a donor or an acceptor at a given temperature will increase with an increase in concentration of compensating species so that, in effect, compensation increases the solubility of a dopant.

Moreover to be of practical use, such non-equilibrium incorporation needs to persist over reasonable time scales at operating temperatures, so that the mobility of the desired dopant needs be low enough that the dopant remains locked in the crystal lattice after the initial non-equilibrium incorporation.

Various techniques are feasible for achieving non-equilibrium incorporation. The simplest is to introduce the desired dopant species at a temperature where its mobility and solubility is high, with subsequent fast quenching to a lower temperature where the mobility is low, to lock the dopant in the lattice. A variant of this has been suggested in which the preferred site of an amphoteric dopant can be a function of temperature. However, these techniques for achieving a non-equilibrium concentration have been of limited usefulness, particularly with respect to wide-band gap materials that are difficult to make "well-conducting".

A feature of the present invention is an approach to achieving a non-equilibrium concentration that uses consciously, with optimum parameters, phenomena that may have been accidentally involved in the past. In the technique of the invention, a desired primary dopant species is introduced into the semiconductor of interest together with a concentration, preferably nearly the same, of a suitable secondary compensating species, advantageously one more mobile at lower temperatures. The compensating species acts to increase the solubility of the desired dopant so that the concentration introduced of the desired dopant may be larger than the equilibrium value in the absence of the compensating species. Subsequently, in disciplined fashion, the more mobile compensating species is preferentially removed. Introduction of a chosen mobile compensating species, of a concentration closely matching that of the desired dopant, will prevent or reduce the incorporation of other, possibly less mobile compensating species. In this case, after the removal of the selected mobile compensating species, the dopant remaining in the host crystal will be predominantly only the desired dopant whereby the material may be of high conductivity of the type imparted by the desired dopant.

Thus, the present invention provides a process for the non-equilibrium incorporation of a dopant into a crystal of a wide band gap semiconductor, the process comprising the steps of simultaneously introducing substantially equal amounts of first and second compensating dopants of different mobilities into at least a portion of the crystal such that the concentration of the less mobile of the two dopants in the portion of the crystal is in excess of the solubility of the less mobile dopant therein in the absence of the more mobile of the two dopants, and then selectively removing therefrom the more mobile of the two dopants whereby there is left a non-equilibrium concentration of the less mobile dopant in the portion of the crystal.

In an illustrative example of a process in accordance with the invention, a layer or zinc selenide is doped p-type with nitrogen by liquid phase epitaxial (LPE) growth from a lithium-rich melt. The doping with nitrogen may be achieved by using ammonia (NH₃) essentially in the manner described in a paper entitled "Ionization energy of the shallow nitrogen acceptor in zinc selenide" published in Physical Review B, Vol. 27, Number 4, 15th February 1983, pps. 2419-2428. In the resulting layer, nitrogen is substituted in selenium sites as an acceptor, and lithium is incorporated in interstitial sites where it acts as a donor. Subsequent to its growth, the layer is heated to a temperature of about 900°C in zinc vapor together with indium, gallium or thallium vapor. This heating tends to getter the faster diffusing lithium selectively from the layer whereby it is left doped primarily by nitrogen and so is a high conductivity p-type.

If a p-n junction is to be formed, an n-type zinc selenide crystal nay be used as the substrate in the LPE process in which the lithium-nitrogen epitaxial layer is grown. Advantageously the crystal used as the substrate is n-type by the inclusion, as the predominant dopant, of a donor, such as iodine, that diffuses only slowly in the zinc selenide, so that little of it is lost during the lithium gettering step.

Additionally, hydrogen can be introduced simultaneously with the desired primary dopant in substantially equivalent amounts such that the concentration of the primary dopant in the zinc selenide is in excess of the solubility of the primary dopant alone to produce either n-type or p-type material. Hydrogen may act as a donor impurity to compensate p-type dopants, or act as an acceptor impurity to compensate n-type dopants. In either case, the effective solubility of the desired dopant will be increased, and after preferential removal of the more mobile hydrogen, the resistivity of the semiconductor bulk will be lower than that which can be achieved with introduction of the desired dopant alone.

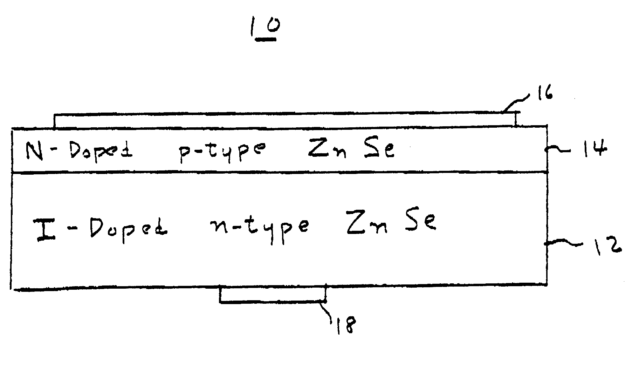

The invention will now be described in more detail by way of example only, and in conjunction with the accompanying drawing that shows a p-n diode of ZnSe made in accordance with an illustrative embodiment of the invention.

### DETAILED DESCRIPTION OF THE INVENTION

A p-n junction zinc selenide diode 10 including layers 12 and 14, suitable for use as a light-emitting diode, shown in the drawing, is prepared as follows.

There is first prepared the n-type slice 12 of zinc selenide in known fashion, for example, as described in a paper entitled "p-n junction zinc sulfo-selenide and zinc selenide light-emitting diodes" Applied Physics Letters, Vol. 27 No. 2, 15 July 1975 pps. 74-77. This involves preparing a single crystal boule of n-type zinc selenide by an iodine transport technique, cutting a slice parallel to the (111) plane, and annealing the slice in molten zinc. The resulting material is made to have a resistivity of the order of 0.1 ohm-cm., corresponding to an iodine concentration of between 10¹⁷ and 10¹⁸ per cc³. The slice desirably is about 1 mm. thick and 0.5 cm radius.

Thereafter, there is grown on one surface of the n-type slice 12, an epitaxial p-type layer 14, typically between 5 and 10 microns thick, although even thinner layers can be used. This layer advantageously is grown by LPE to include both lithium and nitrogen in appropriate amounts in the manner described previously with reference to the Physical Review B paper. The amounts added are best determined experimentally but should be adequate to provide, in the epitaxial layer grown, substantially equal concentrations of lithium and nitrogen, advantageously in the range between 10¹⁷ and 10¹⁸ per cc³. As long as the amounts of each in the melt are approximately equal, because of strong compensating effects in such wide band gap crystals, substantially equal amounts of the two dopants will be introduced into the crystal. Because the presence of the lithium increases the effective solubility of the nitrogen, there can be introduced into the zinc selenide a normally non-equilibrium concentration, as previously discussed.

Then, in known fashion, the lithium is preferentially removed from the epitaxial layer. This is feasible because of the much lower mobility of nitrogen and iodine in zinc selenide in this temperature range. There results a p-type epitaxial layer with a nitrogen concentration of about 10¹⁷ per cc³. A suitable procedure is to heat the slice in the range of between 600°C-1000°C in zinc vapor together with either indium, gallium, or thallium as suggested in a paper entitled "The variation of residual impurities in Zn Se crystals used in light-emitting diode fabrications", J. Appl. Phys. 53(2) February 1982, pps. 1248-1250.

To complete the diode, a thin layer 16 of gold is deposited over the p-type layer to serve as one of the two electrodes of the diode. A dot 18 of indium is deposited over the bottom surface of the slice to serve as the other electrode of the diode. This leaves a considerable portion of the bottom surface free for the exit of the emitted light excited when an appropriate voltage is applied between the two electrodes. Such a diode emits blue light of about 460 µm wavelength.

Of course, other electrode configurations are possible, including ring-shaped electrodes, to facilitate the exit of the emitted light.

Additionally, the principles of the invention are applicable to the preparation of devices using wide band gap semiconductors other than zinc selenide.

A light-emitting p-n junction diode can be formed in zinc telluride in accordance with an alternative embodiment of the invention as follows.

A p-type crystal of ZnTe was grown from a Te rich solution by a Bridgman technique, as discussed in a paper entitled "SEM and Photoluminescence Study of Li Segregation in Annealed Zinc Telluride" published in Solid State Communications Vol. 29, pps. 35-38, Pergamon Press Ltd. 1979.

Then in known fashion, using metal-organo-chemical vapor deposition (MOCVD), an n-type epitaxial layer is grown on the top surface of the slice. In this case, the epitaxial layer is doped with chlorine as the primary dopant and lithium as the compensating or secondary dopant. Chlorine is a donor in zinc telluride at a tellurium substitutional site while lithium acts as an acceptor on a zinc substitutional site. Moreover, because of its larger ionic size, chlorine will be less mobile than will the lithium.

As before, the presence of the lithium will permit the introduction into the epitaxial layer of a higher concentration of the chlorine than normally possible, as discussed above, by increasing its effective solubility. Again, the amounts of each introduced into the epitaxial layer are made to be about equal.

Then, the zinc telluride slice is heated in a zinc atmosphere to remove the more mobile lithium preferentially as, for example, is reported in a paper entitled "SEM and Photoluminescence Study of Li Segregation in Annealed Zinc Telluride", Solid State Communications, Vol. 29, pps. 35-38, Pergamon Press Ltd. 1979. Accordingly, chlorine becomes the predominant dopant in the epitaxial layer, whereby it becomes n-type. As before appropriate electrodes are provided to the opposite surfaces of the slice to form the diode.

In an alternative embodiment of the invention, hydrogen is utilized as a secondary compensating dopant and is simultaneously diffused into the semiconductor with the desired primary dopant at an appropriate temperature. Hydrogen is also amphoteric in that it can be either a compensating donor or a compensating acceptor.

A more extensive discussion can be found in Pearton, S.J. et al, Appl. Phys. A 43, 153 (1987); and Johnson, N.M. et al, Phys. Rev. Lett. 56, 769 (1986); Acceptors in CdTe have been neutralized with the introduction of hydrogen at about 350°C as further discussed in Boudoukha, A., et al, J. Cryst. Growth 72, 226 (1985). Hydrogen will also act as a donor when introduced into ZnO at about 500-700° as more fully discussed in Thomas, P.G., et al, J. Chem. Phys. 25. 1136 (1956).

Introducing hydrogen as a compensating dopant together with the desired dopant increases the solubility of the desired dopant to be greater than if introduced alone. Subsequently, the hydrogen is preferentially removed and a semiconductor having much reduced compensation of the desired dopant and therefore much lower resistivity is achieved. This alternative embodiment can yield acceptably low resistivity p-type CdS, CdSe, znS, and ZnSe, in addition to other wide band-gap semiconductors which have a tendency to incorporate donor compensators. Moreover, the same techniques may also be used to produce acceptably low resistivity n-type diamond and znTe, as well as other semiconductors which have a tendency to incorporate acceptor compensators.

A first method of introducing hydrogen as a secondary compensating species and the desired primary dopant simultaneously into the crystal structure is via the joint diffusion technique. Some dopants will diffuse at fairly low temperatures. For a review of diffusion rates, see Casey, Jr., H.C., et al., "Point Defects in Solids," Crawford, Jr., J.H. et al., Eds., Vol. 2, p. 163 (Plenum Press, N.Y. 1975). Accordingly, a wide range of conditions and temperatures are available for the simultaneous introduction of H and a primary dopant by joint diffusion.

Hydrogen and the desired primary dopant can also be introduced simultaneously during crystal growth. One requirement is that the growth temperature be sufficiently low in order to retain hydrogen in the semiconductor. Therefore, a temperature of approximately 700°C or below is desirable. Yet another technique of simultaneous hydrogen and dopant introduction is to use known ion implantation techniques.

As an example, p-type zinc selenide can be produced by conventional methods at usual high temperatures, to wit, 400°C or above. P-type zinc selenide may typically have sodium at the Zn substitutional site and/or nitrogen at the Se substitutional site. Hydrogen is simultaneously introduced with the desired primary acceptor dopant and, under these circumstances, acts like a donor impurity which effectively compensates the simultaneously introduced acceptor impurity and increases the solubility of the acceptor impurity. Typically, p-type zinc selenide tends to become heavily compensated by donors such as Group I metals going to the interstitial sites. Compensation also occurs if contaminating donors are unintentionally introduced into the zinc selenide substrate. Because hydrogen is made available in a relatively high concentration, it will act as a compensating donor and significantly limit the presence of contaminating donors. Once the hydrogen is preferentially removed, p-type zinc selenide having suitably low compensation and consequently, suitably low resistivity, will remain.

Several methods are known for selectively removing the compensating hydrogen while allowing the desired acceptor or donor impurity to remain in the semiconductor. For example, the material can be heated to a temperature which is sufficient to cause relatively rapid out-diffusion of hydrogen from the material as compared to the rate of out-diffusion of the primary dopant at the same temperature. Temperatures between about 100 and 500°C and, more preferably, between about 150 and 450°C are generally effective. The actual preferred temperature depends on many factors including the specific primary dopant species used. Due to the high mobility of hydrogen, it will diffuse out while allowing the less mobile primary dopant to remain in the semiconductor. A temperature of approximately 250°C has been shown to be effective for this procedure.

Other known methods for extracting the hydrogen may be used. For example, a gettering process may be used in which the semiconductor, such as p-type zinc selenide, would be heated in the presence of a metal which has an affinity for hydrogen. In another known method, the hydrogen is removed through electric field induced hydrogen drift. Any method which would remove the hydrogen without appreciably removing the desired dopant(s) may be used in accordance with the invention.

Certain semiconductor materials having compensation problems when n-type dopants are introduced. These problems may also be alleviated by the method of this invention. For example, it has not been heretofore practicable to produce high conductivity n-type ZnTe having a resistivity below 100 ohm-cm. To produce such high conductivity n-type ZnTe, hydrogen is introduced simultaneously with an appropriate desired donor dopant, such as chlorine. The semiconductor is allowed to cool, and the hydrogen is then extracted by any of the aforementioned methods, at a much lower temperature than the temperature at which the hydrogen and desired donor dopant was introduced. The resulting n-type ZnTe will have substantially lower compensation and correspondingly lower resistivity.

It should be evident that the basic principles described can be extended to various other systems of wide band gap materials and should be of special interest to materials that are normally difficult to dope adequately.

Basically, as described, by choosing an appropriate compensating pair of primary and secondary dopants, the amount of primary dopant introduced into a crystal may be larger than the solubility of the primary dopant in the crystal if introduced alone. Thereafter by the removal preferentially of the secondary dopant, typically by taking advantage of its higher mobility in the crystal, the crystal is left with a higher, non-equilibrium concentration of the primary dopant. Copper and gold are other examples of likely choices for use as the secondary dopant.

It should also be apparent that the invention should make feasible the formation of various other forms of electronic devices, such as transistors and injection lasers.

Additionally, while there have been described embodiments using LPE and MOCVD for forming layers including compensating pairs of primary and secondary dopants, other techniques are feasible including molecular beam epitaxy (MBE).

## Claims

1. A process for the non-equilibrium incorporation of a dopant into a crystal (12,14) of a wide band gap semiconductor, the process comprising the steps of simultaneously introducing substantially equal amounts of first and second compensating dopants of different mobilities into at least a portion (14) of the crystal (12,14) such that the concentration of the less mobile of the two dopants in the portion (14) of the crystal is in excess of the solubility of the less mobile dopant therein in the absence of the more mobile of the two dopants, and then selectively removing therefrom the more mobile of the two dopants whereby there is left a non-equilibrium concentration of the less mobile dopant in the portion (14) of the crystal.

2. A process according to Claim 1, wherein the semiconductor is zinc selenide and the more mobile dopant is lithium and the less mobile dopant is nitrogen.

3. A process according to Claim 1, wherein the semiconductor is zinc selenide and the more mobile dopant is hydrogen and the less mobile dopant is nitrogen.

4. A process according to Claim 1, wherein the semiconductor is zinc telluride and the more mobile dopant is lithium and the less mobile dopant is chlorine.

5. A process according to Claim 1, wherein the semiconductor is zinc telluride and the more mobile dopant is hydrogen and the less mobile dopant is chlorine.

6. A process according to Claim 1, wherein the more mobile dopant can move via interstitial sites and the less mobile dopant is at a substitutional site in the crystal.

7. A process for forming a p-n junction diode comprising the steps of preparing a substrate crystal (12) of a wide band gap semiconductor of one conductivity type and growing on a surface of the crystal (12) an epitaxial layer (14) comprising a crystal (14) produced by a process according to any one of the preceding claims characterised in that the less mobile dopant is characteristic of a conductivity type opposite that of the substrate crystal (12) and the two dopants are introduced into the epitaxial layer (14) in the course of its epitaxial growth.

## Patentansprüche

1. Verfahren zum Ungleichgewichtseinbau eines Dotierstoffes in einem Kristall (12,14) eines Halbleiters mit großer Bandlücke, wobei das Verfahren die Schritte aufweist: gleichzeitiges Einbringen im wesentlichen gleicher Mengen erster und zweiter Ausgleichsdotierstoffe unterschiedlicher Beweglichkeiten in mindestens einen Abschnitt (14) des Kristalls (12,14), so daß die Konzentration des weniger beweglichen der beiden Dotierstoffe im Abschnitt (14) des Kristalls die Löslichkeit des weniger beweglichen Dotierstoffes darin in der Abwesenheit des beweglicheren der Dotierstoffe überschreitet, und dann selektives Entfernen daraus des beweglicheren der beiden Dotierstoffe, wodurch eine Ungleichgewichtskonzentration des weniger beweglichen Dotierstoffes im Abschnitt (14) des Kristalls hinterlassen wird.

2. Verfahren nach Anspruch 1, wobei der Halbleiter Zinkselenid ist und der beweglichere Dotierstoff Lithium ist und der weniger bewegliche Dotierstoff Stickstoff ist.

3. Verfahren nach Anspruch 1, wobei der Halbleiter Zinkselenid ist und der beweglichere Dotierstoff Wasserstoff ist und der weniger bewegliche Dotierstoff Stickstoff ist.

4. Verfahren nach Anspruch 1, wobei der Halbleiter Zinktellurid ist und der beweglichere Dotierstoff Lithium ist und der weniger bewegliche Dotierstoff Chlor ist.

5. Verfahren nach Anspruch 1, wobei der Halbleiter Zinktellurid ist und der beweglichere Dotierstoff Wasserstoff ist und der weniger bewegliche Dotierstoff Chlor ist.

6. Verfahren nach Anspruch 1, wobei der beweglichere Dotierstoff sich über Zwischengitterplatze bewegen kann und der weniger bewegliche Dotierstoff sich an einem Substitutionsplatz im Kristall befindet.

7. Verfahren zur Bildung einer pn-Übergang-Diode, das die Schritte aufweist: Herstellen eines Substratkristalls (12) eines Halbleiters mit großer Bandlücke eines Leitfähigkeitstyps und Züchten auf einer Oberfläche des Kristalls (12) eine Epitaxialschicht (14) mit einem Kristall (14), der durch ein Verfahren nach einem der vorhergehenden Ansprüche hergestellt wird, dadurch gekennzeichnet, daß der weniger bewegliche Dotierstoff charakteristisch für einen Leitfähigkeitstyp ist, der entgegengesetzt zu jenem des Substratkristalls (12) ist, und zwei Dotierstoffe in die Epitaxialschicht (14) im Verlauf ihrer Epitaxie eingebracht werden.

## Revendications

1. Procédé d'incorporation en quantité non équilibrée d'un dopant dans le cristal (12, 14) d'un semi-conducteur à large écart énergétique, ce procédé comprenant les étapes consistant à introduire simultanément dans au moins une des parties (14) du cristal (12, 14) des quantités sensiblement égales d'un premier et d'un second dopant de compensation dont les mobilités sont différentes de telle sorte que la concentration du moins mobile des deux dopants dans la partie (14) du cristal est en excès par rapport à sa solubilité dans cette partie en l'absence du dopant le plus mobile, puis à extraire de manière sélective le plus mobile des deux dopants de telle manière que demeure une concentration non équilibrée du dopant le moins mobile dans la partie (14) du cristal.

2. Procédé selon la revendication 1, dans lequel le semi-conducteur est le séléniure de zinc et le dopant le plus mobile le lithium et le moins mobile l'azote.

3. Procédé selon la revendication 1, dans lequel le semi-conducteur est le séléniure de zinc et le dopant le plus mobile l'hydrogène et le moins mobile l'azote.

4. Procédé selon la revendication 1, dans lequel le semi-conducteur est le tellurure de zinc et le dopant le plus mobile le lithium et le moins mobile le chlore.

5. Procédé selon la revendication 1, dans lequel le semi-conducteur est le tellurure de zinc et le dopant le plus mobile l'hydrogène et le moins mobile le chlore.

6. Procédé selon la revendication 1, dans lequel le dopant le plus mobile peut se déplacer va des sites interstitiels alors que le dopant le moins mobile se trouve sur un site de substitution dans le cristal.

7. Procédé pour former des diodes à jonction PN comprenant les étapes consistant à préparer un cristal substrat d'un type de conductivité et à tirer à la surface de ce cristal (12) une couche épitaxiale (14) comprenant un cristal produit par le procédé selon l'une quelconque des revendications précédentes, caractérisé en ce que le dopant le moins mobile est caractéristique d'un type de conductivité opposée à celle du cristal substrat (12) et les deux dopants sont introduits dans la couche épitaxiale (14) pendant le tirage de celle-ci.
